# EUROPEAN PATENT SPECIFICATION

(11) **EP 4 422 373 B1**
(45) Date of publication and mention of the grant of the patent: **31.12.2025**
(21) Application number: 22922341.7
(22) Date of filing: 24.11.2022
(51) Int. Cl.: G06F 1/16, H05K 7/20, G02F 1/1333, H10K 50/87

(54) **DISPLAY DEVICE**
ANZEIGEVORRICHTUNG
DISPOSITIF D'AFFICHAGE

(30) Priority: 19.01.2022 KR 20220008127
(43) Date of publication of application: 28.08.2024
(73) Proprietor: Samsung Electronics Co., Ltd., Suwon-si, Gyeonggi-do 16677 (KR)
(72) Inventor: KIM, Kyungbae, Suwon-si Gyeonggi-do 16677 (KR); KIM, Beomhan, Suwon-si Gyeonggi-do 16677 (KR); KIM, Sru, Suwon-si Gyeonggi-do 16677 (KR); KIM, Yeonho, Suwon-si Gyeonggi-do 16677 (KR); KIM, Hyeonglae, Suwon-si Gyeonggi-do 16677 (KR)
(74) Representative: Appleyard Lees IP LLP
(86) International application number: PCT/KR2022/018665
(87) International publication number: WO 2023/140483

(56) References cited:
- EP-A1- 3 217 654
- CN-A- 108 766 981
- KR-A- 20130 074 184
- KR-A- 20160 142 400
- KR-A- 20180 130 352
- KR-A- 20210 009 716
- US-A1- 2014 376 191
- US-A1- 2021 116 958

## Description

### Technical Field

The present disclosure relates to a display device, and more particularly, to a display device including insulation region.

### Background Art

In general, display devices are a type of output device that visually displays data information, such as text, shapes, and the like, as well as images and the like.

Display devices may be classified into two types: self-emissive, which includes display panels that emit light by themselves, such as organic light emitting diodes (OLEDs), and non-emissive, which includes display panels that do not emit light by themselves, such as liquid crystal displays (LCDs) and require light to be supplied by a backlight unit.

In a self-emissive display device, the backlight unit may be omitted, which has the advantage of reducing the thickness of the display device. However, such a thin structure may result in the direct transfer of heat generated by electrical components located at the rear of the display panel.

EP3217654A1, US2021/116958A1, US2014/376191A1, and KR20180130352A relate to display devices which are designed to mitigate the direct transfer of heat generated by electrical components located at the rear of the display panel.

### Disclosure

### Technical Problem

An aspect of the present disclosure provides a display device capable of preventing heat generated by electrical components from directly contacting a display panel.

An aspect of the present disclosure provides a display device capable of preventing heat generated by electrical components from directly contacting a display panel without the need for complex processes.

### Technical Solution

According to an embodiment of the disclosure, a display device includes a display panel, an electrical component located on a rear side of the display panel and releasing heat, and an inner plate located on the rear side of the display panel, wherein the inner plate includes an inner plate body, and an insulation region formed at a position corresponding to a position of the electrical component and having a heat transfer coefficient lower than a heat transfer coefficient of the inner plate body to reduce transfer of heat generated from the electrical component to the display panel,
wherein an insulating through hole is formed in the insulation region to allow an air gap to be formed between the electrical component and the display panel, wherein
the insulating through hole is formed by cutting the inner plate, further comprising a rear chassis attached to a rear side of the inner plate to support the display panel,
wherein the electrical component is mountable on a rear side of the rear chassis, the rear chassis includes a heat transfer portion at a position corresponding to the electrical component, and the insulating through hole is formed to correspond to the heat transfer portion.

The rear chassis and the inner plate may be attached by an adhesive member located between the rear chassis and the inner plate, and the air gap may be formed to extend from a front side of the rear chassis to the insulating through hole.

A strength of the inner plate and the rear chassis may change by 10% or less when the insulating through hole is formed.

The rear chassis may include a rear chassis body including the heat transfer portion, and a spacing bead protruding from the rear chassis body toward the electrical component to form a spacing gap between the electrical component and the heat transfer portion.

The electrical component may include a first electrical component and a second electrical component, the heat transfer portion may include a first heat transfer portion corresponding to the first electrical component and a second heat transfer portion corresponding to the second electrical component, the spacing bead may include a first spacing bead formed at a position corresponding to a position of the first electrical component and located adjacent to the first heat transfer portion, and a second spacing bead formed at a position corresponding to a position of the second electrical component, protruding further rearward than the first spacing bead, and located adjacent to the second heat transfer portion, and the insulating through hole may be formed on a front side of the first heat transfer portion.

The display device may further include a rear cover disposable on the rear side of the rear chassis to cover the first electrical component and the second electrical component, wherein a thickness of the first electrical component in a front-to-back direction may be thicker than a thickness of the second electrical component in the front-to-back direction.

The first electrical component may include a power board, and the second electrical component may include a display control board.

The power board may include a transformer enabled to convert an alternating current voltage into a direct current voltage, and the insulation region may be formed to correspond to a position of the transformer.

A size of the air gap may be 1 mm or less.

The display device may further include a stand disposed on a rear side of the rear cover and supporting the display panel, wherein the second electrical component may be located facing the stand, and the first electrical component may be located adjacent to the second electrical component.

A substrate controlling the display panel may be arranged on a lower side of the rear chassis, and the insulation region may be positioned to be spaced apart from the substrate.

A first heat transfer path may be formed in which heat from the electrical component flows through the rear chassis and the inner plate body to the display panel, and a second heat transfer path may be formed in which heat from the electrical component flows through the rear chassis and bypasses the insulation region of the inner plate to the display panel.

### Advantages Effects

According to various embodiments of the present disclosure, the display device may include the inner plate formed at a position corresponding to the electrical components and including an insulation region having a lower heat transfer coefficient than the inner plate body, so that heat generated by the electrical components does not directly contact the display panel.

According to various embodiments of the present disclosure, the display device may form the insulating through hole on the inner plate to allow the air gap to be formed between the electrical components and the display panel, so that heat generated by the electrical component does not directly contact the display panel without undergoing complex processes.

### Description of Drawings

FIG. 1 is a perspective view of a display device according to an embodiment of the present disclosure.
FIG. 2 is a rear perspective view of the display device of FIG. 1.
FIG. 3 is an exploded view of the display device of FIG. 1.
FIG. 4 is an exploded rear view of the display device of FIG. 1.
FIG. 5 is a perspective view illustrating a rear structure of an inner plate in the display device of FIG. 1.
FIG. 6 is an exploded view illustrating a disassembled configuration shown in FIG. 5 with the rear cover omitted.
FIG. 7 is an exploded view illustrating a rear chassis and electrical components disassembled in the configuration shown in FIG. 5.
FIG. 8 is a cross-sectional view of FIG. 5, omitting a stand and cutting along line A-A'.
FIG. 9 is a cross-sectional view of FIG. 5, omitting the stand and cutting along line B-B'.
FIG. 10 is a cross-sectional view of FIG. 5, omitting the stand and cutting along line C-C'.
FIG. 11 is a cross-sectional view conceptually illustrating a cutaway section of the display device of FIG. 1.
FIG. 12 is a cross-sectional view conceptually illustrating a cutaway section of the display device of FIG. 1, according to another embodiment of the present disclosure.

### Modes of the Invention

Embodiments described in the disclosure and configurations shown in the drawings are merely examples of the embodiments of the disclosure and may be modified in various different ways at the time of filing of the present application to replace the embodiments and drawings of the disclosure.

In addition, the same reference numerals or signs shown in the drawings of the disclosure indicate elements or components performing substantially the same function.

Also, the terms used herein are used to describe the embodiments and are not intended to limit and/or restrict the disclosure. The singular forms "a," "an" and "the" are intended to include the plural forms as well, unless the context clearly indicates otherwise. In this disclosure, the terms "including", "having", and the like are used to specify features, figures, steps, operations, elements, components, or combinations thereof, but do not preclude the presence or addition of one or more of the features, figures, steps, operations, elements, components, or combinations thereof.

It will be understood that, although the terms "first", "second", "primary", "secondary", etc., may be used herein to describe various elements, but elements are not limited by these terms. These terms are only used to distinguish one element from another element. For example, without departing from the scope of the disclosure, a first element may be termed as a second element, and a second element may be termed as a first element. The term of "and/or" includes a plurality of combinations of relevant items or any one item among a plurality of relevant items.

As used herein, the terms "front", "rear", "upper", "lower", "left", "right", and the like are defined with reference to the drawings and are not intended to limit the shape and location of each component.

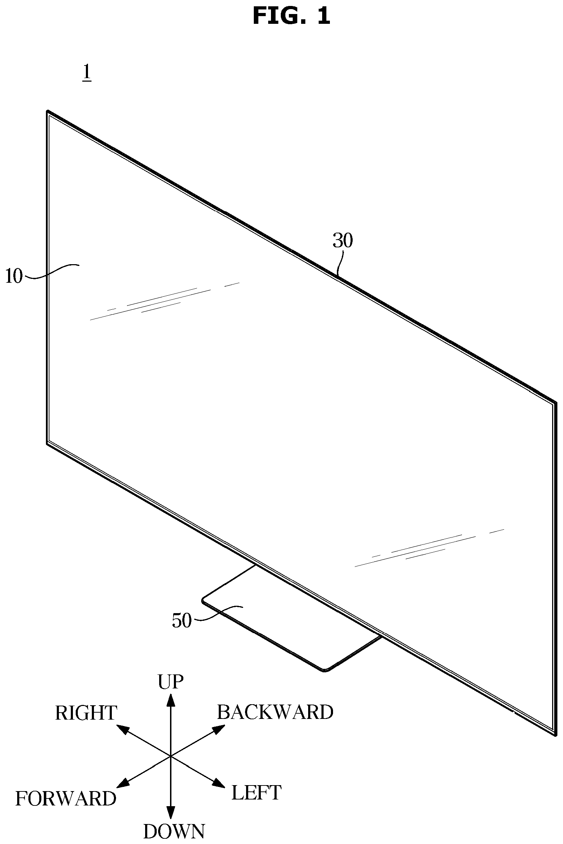

More specifically, as shown in FIG. 1, a direction in which a display panel 10 is facing may be defined as front, and with reference thereto, rear, left and right sides, and upper and lower sides may be defined.

Hereinafter, various embodiments according to the present disclosure will be described in detail with reference to the accompanying drawings.

FIG. 1 is a perspective view of a display device 1 according to an embodiment of the present disclosure.

The display device 1 is a device that processes an image signal received from an external source and visually displays the processed image. In the following, the case where the display device 1 is a television (TV) is exemplified, but is not limited thereto. For example, the display device 1 may be implemented in various forms, such as a monitor, a portable multimedia device, and a portable communication device, or the like, and may have any form as long as it is a device for visually displaying images.

Furthermore, the display device 1 may be a large format display (LFD) installed outdoors, such as on the roof of a building or a bus stop. Here, the outdoors is not necessarily limited to outdoor places, and the display device 1 according to an embodiment may be installed in any place where a large number of people may enter and leave, even if indoors, such as a subway station, a shopping mall, a movie theater, a company, a store, and the like.

The display device 1 may receive content including video signals and audio signals from various content sources, and may output video and audio corresponding to the video signals and audio signals. For example, the display device 1 may receive content data via a broadcast reception antenna or a wired cable, receive content data from a content playback device, or receive content data from a content delivery server of a content provider.

As shown in FIG. 1, the display device 1 may include the display panel 10 facing forward to display an image.

The display panel 10 may include a self-emissive display element or a non-emissive display element.

The self-emissive display element may be capable of visually outputting images by emitting light by itself without a separate light source. For example, a light emitting diode (LED), an organic light emitting diode (OLED), or a quantum dot-organic light emitting diode (QD-OLED), a Micro LED made of an inorganic light emitting material, and the like may be elements capable of emitting light by itself based on a supplied current.

The non-emissive display element may include a non-emissive display element that requires a separate light source. For example, a liquid crystal display (LED), which is a non-emissive display element, may change the arrangement of liquid crystals by an electric current, but require the separate light source to visually output images through the changed arrangement of liquid crystals.

The display device 1 of the present disclosure may be applied to both the display panel 10 having self-emissive display elements and the display panel 10 having non-emissive display elements. However, for ease of description, the following description will be made assuming that the display panel 10 includes self-emissive display elements.

The display panel 10 may include a stand 50 for stably installation. The following description will be made assuming that the stand 50 may include a surface that supports the load of the display panel 10 to prevent the display panel 10 from tipping over from a lower side of the display panel 10. However, the present disclosure is not limited thereto, and the stand 50 may include supporting the display panel 10 from a rear side of the display panel 10 by securing the display device 10 to a wall.

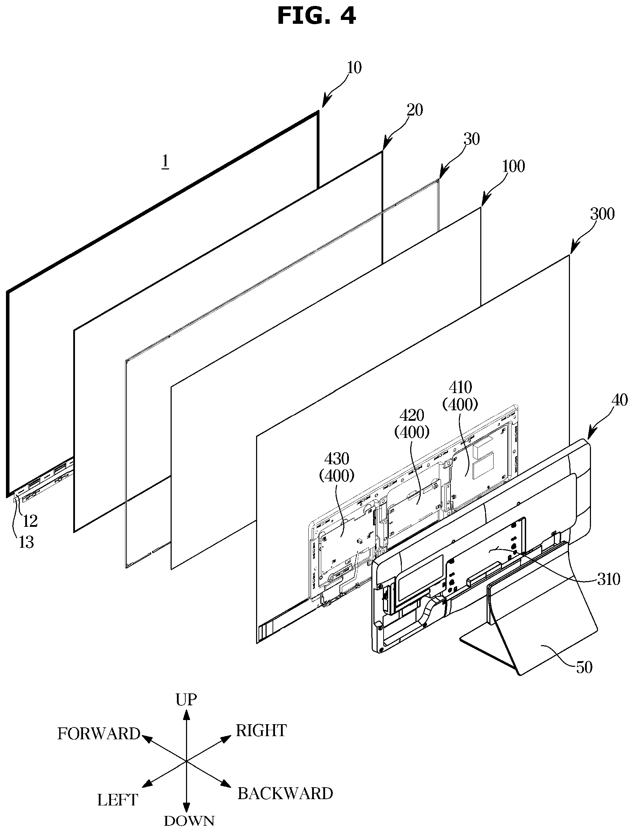

The stand 50 may be coupled with a rear chassis 300 (see FIG. 4) or a rear cover 40 (see FIG. 4) to support the display panel 10.

For ease of description, it is assumed that the stand 50 may be arranged singly at a position corresponding to the center of the display panel 10. However, the present disclosure is not limited thereto, and the ideas embodied in the present disclosure may also be applied to the display device 1 in which the stand is arranged symmetrically on the left and right with respect to the center of the display panel 10, or the stand 50 is provided in a plurality.

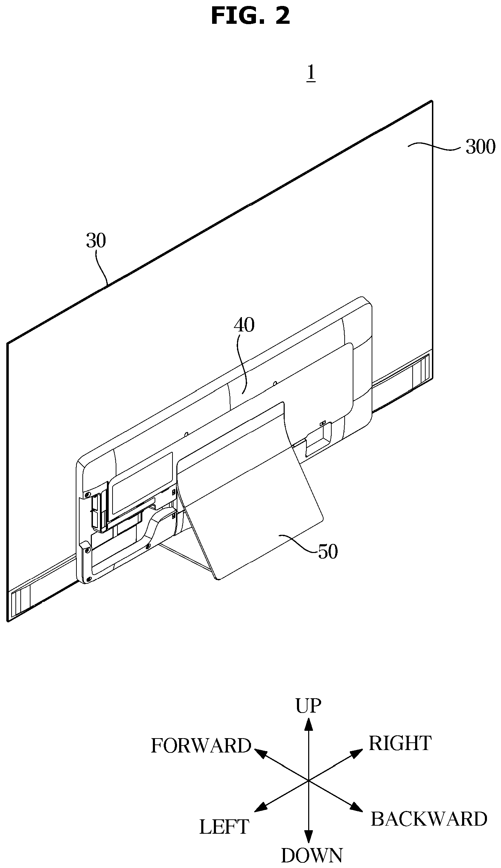

FIG. 2 is a rear perspective view of the display device 1 of FIG. 1.

As shown in FIG. 2, a rear exterior of the display device 1 may be formed by the rear chassis 300 and the rear cover 40.

The rear cover 40 may be coupled to a rear side of the rear chassis 300. The rear cover 40 may be coupled to the rear side of the rear chassis 300, for example, at a lower center thereof. The rear cover 40 may be arranged to cover a portion of the rear chassis 300. The remaining portion of the rear chassis 300 that is not covered by the rear cover 40 may have a thickness that is thinner than the above portion. According to an embodiment, a portion of the display device 1 having the largest thickness may be the portion where the rear cover 40 is arranged. The larger the area of the rear cover 40, the larger the area of the portion of the display device 1 having a greater thickness. Accordingly, reducing the area of the rear cover 40 may allow a user to feel that the overall thickness of the display device 1 is thinner. According to the present disclosure, an ultra-slim appearance of the display device 1 may be achieved by minimizing the area of the rear cover 40.

More particularly, one end of the rear cover 40 and one end of the rear chassis 300 may be spaced apart by a predetermined distance. Similarly, the other end of the rear cover 40 and the other end of the rear chassis 300 may be spaced apart by the predetermined distance. In other words, the left end of the rear cover 40 and the left end of the rear chassis 300 may be spaced apart by a first distance, and the right end of the rear cover 40 and the right end of the rear chassis 300 may be spaced apart by the first distance. Such a configuration may allow a peripheral portion on both sides of the display device 1 and a peripheral portion on an upper surface of the display device 1 to be very thin.

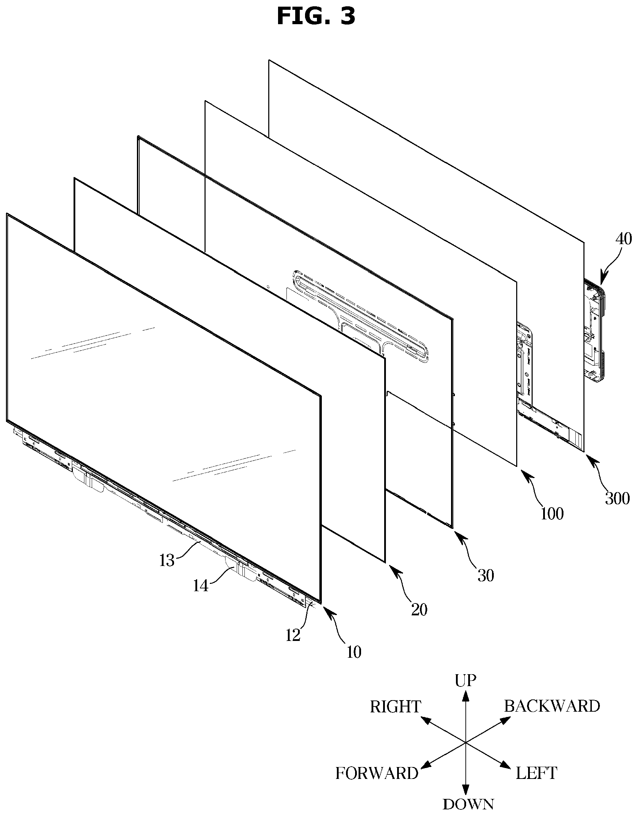

FIG. 3 is an exploded view of the display device 1 of FIG. 1. FIG. 4 is an exploded rear view of the display device 1 of FIG. 1.

As shown in FIGS. 3 and 4, the display device 1 may include the display panel 10, a front chassis 30 extending along a perimeter of the display panel 10 to cover a side of the display panel 10, the rear chassis 300 arranged to cover a rear surface of the display panel 10, and the rear cover 40 arranged to cover a portion of the rear surface of the rear chassis 300. In addition, the display device 1 may further include an inner plate 100 coupled to a front side of the rear chassis 300 to dissipate heat generated by the display panel 10.

The display device 10 may include a heat dissipation sheet 20 attached to the rear surface of the display panel 10 and arranged to dissipate heat. The heat dissipation sheet 20 may be provided in a size corresponding to the display panel 10 and may be attached to the rear surface of the display panel 10 by an adhesive, such as a glue or double-sided tape.

As described above, the display panel 10 may be configured to display an image using an OLED. The display panel 10 does not include a backlight unit behind the display panel, and thus may have a thin thickness compared to a non-emissive panel.

A film cable 12 may be provided at a lower end of the display panel 10. The film cable 12 may be coupled to the display panel 10 in the form of a chip-on-film (COF). The film cable 12 may be formed from a flexible material to be bendable. A first end of the film cable 12 may be coupled to the lower end of the display panel 10, and a second end of the film cable 12 may be bent and disposed adjacent to a rear surface of the heat dissipation sheet 20.

A substrate 13 may be disposed at the second end of the film cable 12. The substrate 13 may be configured to transmit a signal to drive the display panel 10. The substrate 13 may be coupled to the rear surface of the heat dissipation sheet 20. The substrate 13 may be attached to the rear surface of the heat dissipation sheet 20 using an adhesive, such as a glue or double-sided tape.

The number of substrates 13 may vary depending on the size of the display panel 10. As the size of the display panel 10 increases, the number of substrates 13 may increase. The display device 1 may include a connection cable 14 provided to connect two adjacent substrates 13 to each other. According to an embodiment, the display device 1 may include four substrates 13, with the connection cable 14 connecting two of the substrates 13 and the connection cable 14 connecting the remaining two substrates 13.

The heat dissipation sheet 20 may be attached to the rear surface of the display panel 10 to dissipate heat. The heat dissipation sheet 20 may increase the contact area with the display panel 10 to effectively absorb heat from the display panel 10. To this end, the heat dissipation sheet 20 and the display panel 10 may be coupled by an adhesive member.

The heat dissipation sheet 20 may include at least one of graphite, aluminum, and copper. In particular, the heat dissipation sheet 20 may include graphite.

The heat dissipation sheet 20 may be arranged to be detachable from the rear chassis 300. In other words, the heat dissipation sheet 20 may not be coupled to the rear chassis 300. Accordingly, the heat dissipation sheet 20 may be detachable from the rear chassis 300 without any restrictions.

The front chassis 30 may be arranged to cover a side surface of the display panel 10. The front chassis 30 may be formed to extend along the perimeter of the display panel 10. Accordingly, the front chassis 30 may be provided in the form of a substantially rectangular ring.

The rear chassis 300 may be arranged to be of a size corresponding to the display panel 10. The rear chassis 300 may be arranged to cover the rear surface of the display panel 10. As described above, the rear chassis 300 may form the rear exterior of the display device 1 together with the rear cover 40.

The inner plate 100 may be arranged in a size corresponding to the rear chassis 300 and may be coupled to a front surface of the rear chassis 300. The inner plate 100 may be coupled to the rear chassis 300 to reinforce the rigidity of the display panel 10 and may be arranged to dissipate heat generated by the display panel 10.

The rear cover 40 may be arranged to cover a portion of the rear surface of the rear chassis 300. The rear cover 40 may be coupled to the rear surface of the rear chassis 300 to form an internal space. In the internal space formed between the rear cover 40 and the rear chassis 300, electrical components 400 including a control board 420, such as a timing controller (T-con) board, a main board 430, and a power board 410 may be arranged.

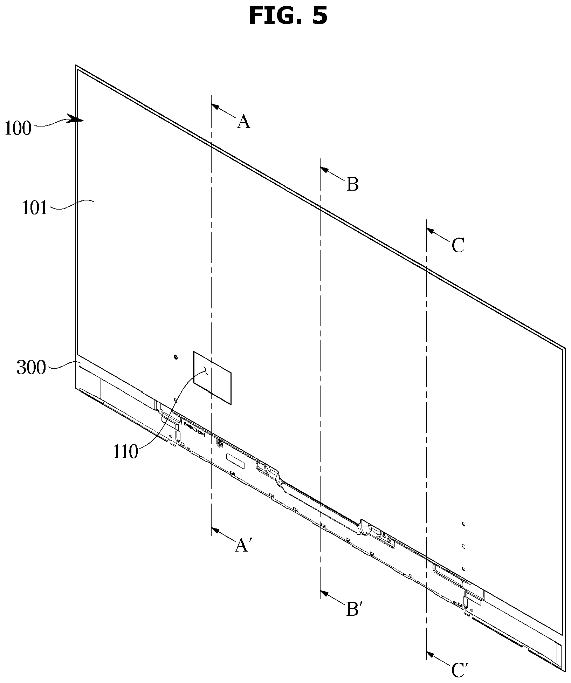

FIG. 5 is a perspective view showing a rear structure of the inner plate 100 in the display device 1 of FIG. 1.

As shown in FIG. 5, the inner plate 100 may include a thermal insulation region 110 (hereinafter referred to as an insulation region) formed at a position corresponding to the electrical components 400 and having a lower heat transfer coefficient than an inner plate body 101, to reduce transfer of heat generated by the inner plate body 101 and the electrical components 400 to the display panel 10.

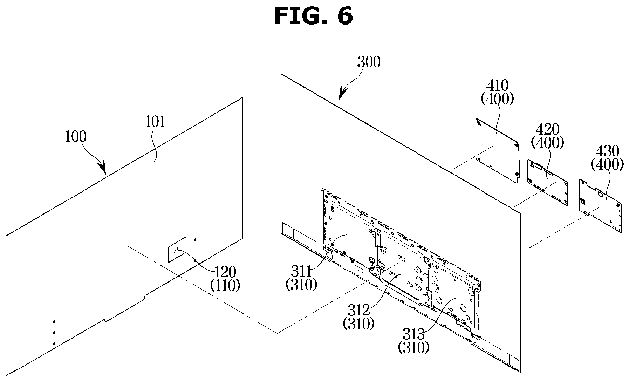

In FIG. 5, the insulation region 110 is shown as being formed singly on only one side of the inner plate 100, but a plurality of insulation regions 110 may be formed when there are a plurality of locations corresponding to the electrical components 400 (see FIG. 6) that generate heat.

Since the insulation region 110 has a lower heat transfer coefficient than the inner plate body 101, the heat generated by the electrical components 400 may be facilitated to flow through the inner plate body 101 rather than through the insulation region 110. As a result, the heat may be dispersed, so that the temperature rise of the display panel 10 caused by the heat generated by the electrical components 400 may be reduced.

FIG. 6 is an exploded view showing a configuration shown in FIG. 5 disassembled in a state in which the rear cover 40 is omitted.

As shown in FIG. 6, the insulation region 110 may have the shape of a hole. The hole formed in the insulation region 110 may be referred to as an insulating through hole 120.

In other words, the insulating through hole 120 may be formed on the insulation region 110 to allow an air gap 130 to be formed between the electrical components 400 and the display panel 10.

The insulating through hole 120 may be formed by cutting the inner plate 100. Since the inner plate 100 may have a metal plate shape, the insulating through hole 120 may be formed through a process of cutting the inner plate 100.

The electrical components 400, which generate (or release) heat, may be mounted on a rear side of the inner plate 100. The electrical components 400 located behind the inner plate 100 may include a first electrical component 410, a second electrical component 420, and a third electrical component 430.

The electrical components 400 may generate heat, and the rear chassis 300 may include a heat transfer portion 310 at a position corresponding to the electrical components 400. Because the heat transfer portions 310 are located closest to the electrical components 400, the heat generated by the electrical components 400 may be transferred to the display panel 10 through the heat transfer portions 310.

As the electrical components 400 may include the first electrical component 410, the second electrical component 420, and the third electrical component 430, the corresponding heat transfer portion 310 may include a first heat transfer portion 311, a second heat transfer portion 312, and a third heat transfer portion 313.

In this case, the first electrical component 410 may include the power board 410. The power board 410 may be a switching mode power supply (SMPS). The power board 410 may provide power to the display panel 10.

The second electrical component 420 may include the control board 420. The control board 420 may be a T-CON. The T-CON may control the timing between the substrates 13 controlling each region of the display panel 10.

The third electrical component 430 may include the main board 430. The main board 430 may control the image displayed on the display panel 10.

At this time, the insulating through hole 120 may be formed to correspond to at least one of the heat transfer portions 310.

The insulating through hole 120 may be formed to correspond to the first electrical component 410, the second electrical component 420, or the third electrical component 430. The inner plate 100 may be a member provided to supplement the rigidity of the display panel 10. The rigidity of the inner plate 100 may be reduced as the insulating through holes 120, which may be formed by cutting the inner plate 100, increase in number and size.

As the temperature of the power board 410 may be higher than that of the control board 420 or the main board 430, the insulating through hole 120 may be formed to correspond only to the power board 410.

Reducing the temperature of the power board 410 may be necessary to. The rear cover 40 may be arranged on a rear side of the electrical components 400, and the stand 50 may be arranged on a rear side of the rear cover 40. In the case where the stand 50 is arranged on the rear side of the electrical components 400, it may become difficult for the electrical components 400 to dissipate heat to the outside. Therefore, the stand 50 may not be arranged on a rear side of the power board 410.

Preferably, the stand 50 may be arranged on a rear side of the control board 420, and the power board 410 may be located adjacent to the control board 420. As a result, the stand 50 may not be arranged on the rear side of the power board 410.

Therefore, the stand 50 may not be arranged on the rear side of the insulating through hole 120.

The power board 410 may include a transformer 411 that converts an alternating current (AC) voltage into a direct current (DC) voltage. In the power board 410, the temperature may be the highest at a portion of the power board 410 where the transformer 411 is disposed. Accordingly, the insulating through hole 120 may be formed to correspond to the position of the transformer 411.

As described above, the substrate 13 for controlling the display panel 10 may be disposed on the lower side of the display panel 10. Since the substrate 13 is susceptible to heat, it may be desirable for an object that generates heat to be located away from the substrate 13. Accordingly, the transformer 411, which generates the most heat in the power board 410, may be positioned spaced apart from the substrate 13.

Since the insulating through hole 120 may be formed to correspond to the position of the transformer 411, the insulating through hole 120 may be spaced apart from the substrate 13. In other words, the insulation region 110 may be positioned spaced apart from the substrate 13.

As such, the insulating through hole 120 may be formed in a portion of the inner plate 100. Due to the formation of the insulating through hole 120, the inner plate 100 may experience a rigidity reduction of 10% or less, preferably 5% or less. In other words, even with the insulating through hole 120 formed, the inner plate 100 may support the display panel 10 and supplement the rigidity of the display panel 10.

For rigidity, the amount of decrease in rigidity may be measured by measuring the degree of bending in a state in which both sides are fixed after the rear chassis 300 and the inner plate 100 are coupled, and then determining the resulting difference.

Alternatively, the amount of decrease in rigidity may be measured by applying a certain weight to the combination of the rear chassis 300 and the inner plate 100, measuring the frequency of the combination of the rear chassis 300 and the inner plate 100, and determining the amount of change in the frequency.

As a result, it can be understood that the formation of the insulating through hole 120 resulted in a temperature decrease of about 1 degree Celsius.

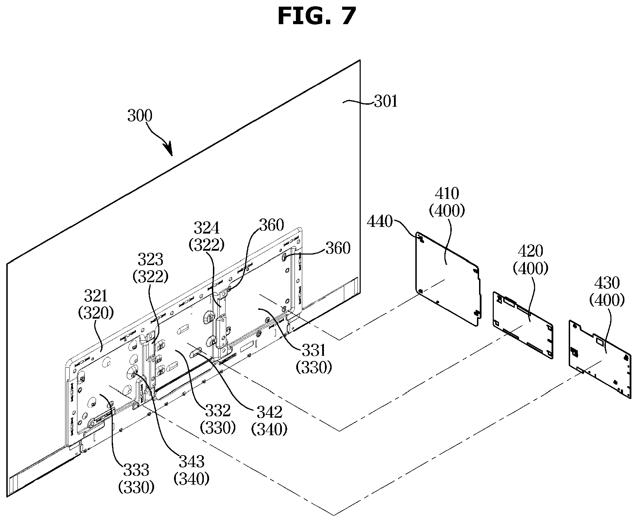

FIG. 7 is an exploded view showing the rear chassis 300 and the electrical components 400 disassembled in the configuration shown in FIG. 5.

As shown in FIG. 7, the rear chassis 300 may be formed with a bead 320 protruding rearwardly from a rear chassis body 301.

The bead 320 may include an edge bead 321 formed surrounding a given section. The edge bead 321 may be arranged surrounding a quadrangular space. The edge bead 321 may be disposed at a lower center of the rear chassis 300.

The bead 320 may be provided with a center bead 322 inside the edge bead 321 to partition the space surrounding the edge bead 321. The center bead 322 may include a first center bead 323 and a second center bead 324 formed to be spaced apart from the first center bead 323. The first center bead 323 may be formed to extend in a vertical direction. The second center bead 324 may be formed to correspond to the first center bead 323.

A mounting portion 330 may be provided by the edge bead 321 and the center beads 322. The electrical components 400 may be mounted on the mounting unit 330. A first mounting portion 331, a second mounting portion 332, and a third mounting portion 333 may be provided by the edge bead 321, the first center bead 323, and the second center bead 324.

The first electrical component 410 may be mounted on the first mounting portion 331. In other words, the power board 410 may be mounted on the first mounting portion 331. The second electrical component 420 may be mounted on the second mounting portion 332. In other words, the control board 420 may be mounted on the second mounting portion 332. The third electrical component 430 may be mounted on the third mounting portion 333. In other words, the main board 430 may be mounted on the third mounting portion 333.

The mounting portion 330 may include spacing beads 340 that protrude toward the rear. The spacing beads 340 may separate the electrical components 400 and the rear chassis 300 when the electrical components 400 are mounted on the mounting portion 330. Since heat may be generated by the electrical components 400, a spacing gap 350 may be formed between the electrical components 400 and the rear chassis 300 to prevent heat generated by the electrical components 400 from being transferred to the rear chassis 300.

In other words, the rear chassis 300 may include the spacing beads 340 protruding from the rear chassis body 301 toward the electrical components 400 to form the spacing gap 350 between the electrical components 400 and the heat transfer portion 310.

The respective electrical components 400 may include a coupling hook 440. The mounting portion 330 of the rear chassis 300 may include a coupling groove 360 into which the coupling hook 440 may be coupled. The coupling groove 360 may be formed corresponding to a position where the coupling hook 440 is mounted. The coupling groove 360 may also be formed on the spacing beads 340. In this case, the coupling groove 360 may be formed on the electrical components 400 and the coupling hook 440 may be formed on the mounting portion 330 of the rear chassis 300. With such a structure, it is possible to use fewer fasteners, such as screws, and to couple the electrical components 400 to the mounting portion 330 of the rear chassis 300.

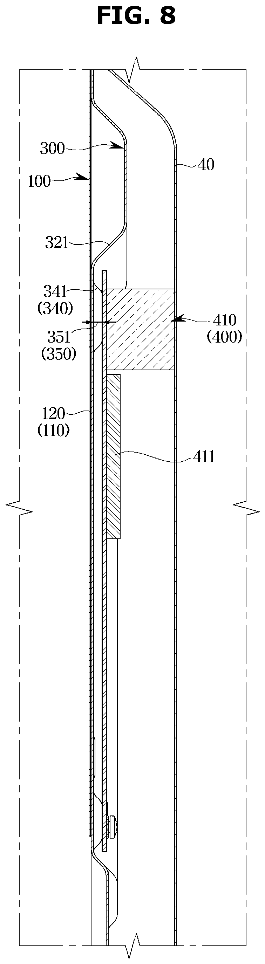

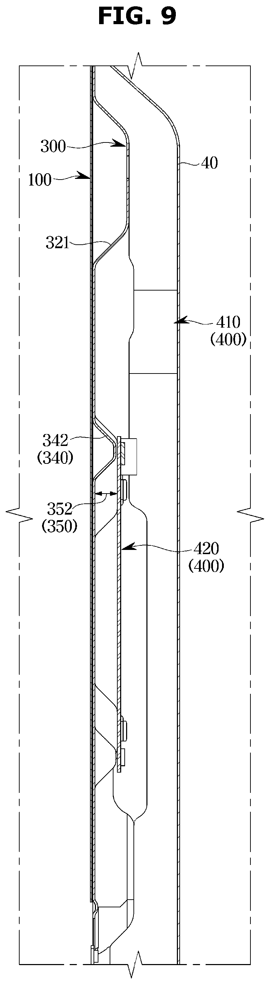

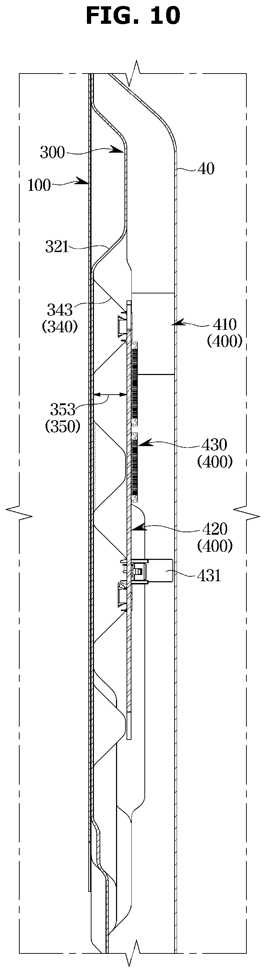

FIG. 8 is a cross-sectional view of FIG. 5 omitting a stand and cutting along line A-A'. FIG. 9 is a cross-sectional view of FIG. 5 omitting the stand and cutting along line B-B'. FIG. 10 is a cross-sectional view of FIG. 5 omitting the stand and cutting along line C-C'.

As shown in FIGS. 8 to 10, the electrical components 400 may be mounted on the rear side of the rear chassis 300.

FIG. 8 is a cross-sectional view centered on the power board 410, and FIG. 9 is a cross-sectional view centered on the control board 420. FIG. 10 is a cross-sectional view centered on the main board 430.

As described above, the rear chassis 300 may include the spacing beads 340 to provide the spacing gap 350 between the electrical components 400 and the rear chassis 300. The greater the spacing gap 350, the less heat generated by the electrical components 400 may be transferred to the rear chassis 300.

For ease of description, it is assumed and described herein that the first electrical component 410 is the power board 410, the second electrical component 420 is the control board 420, and the third electrical component 430 is the main board 430.

Each spacing bead 340 formed to correspond to the power board 410 may be referred to as a first spacing bead 341. The spacing gap 350 formed by the first spacing bead 341 may be referred to as a first spacing gap 351.

Each spacing bead 340 formed to correspond to the control board 420 may be referred to as a second spacing bead 342. The spacing gap 350 formed by the second spacing bead 342 may be referred to as a second spacing gap 352.

Each spacing bead 340 formed to correspond to the main board 430 may be referred to as a third spacing bead 343. The spacing gap 350 formed by the third spacing bead 343 may be referred to as a third spacing gap 353.

The thickness of the power board 410 in a front-to-back direction may be thicker than the thickness of the control board 420 in the front-to-back direction. The thickness in the front-to-back direction of the power board 410 may be thicker than the thickness in the front-to-back direction of the main board 430. In FIG. 10, the thickness of the main board 430 is shown as being thicker than it actually is due to the shape of a connector 431. However, since the connector 431 may be positioned by being bent in up and down, the actual thickness of the power board 410 may be thicker than the main board 430.

The rear cover 40 may be disposed on the rear side of the electrical components 400. The rear cover 40 may have a constant thickness. As a result, among the spacing gaps 350 that may be formed to correspond to the power board 410, the control board 420, and the main board 430, the spacing gap 350 formed to correspond to the power board 410 may be the smallest.

In other words, the spacing beads 340 may include the first spacing bead 341 formed at a position corresponding to the first electrical component 410 and located adjacent to the first heat transfer portion 311, and the second spacing bead 342 formed at a position corresponding to the second electrical component 420, protruding further rearward than the first spacing bead 341, and located adjacent to the second heat transfer portion 312.

In summary, the power board 410 may have a higher temperature compared to the control board 420 and the main board 430, and the corresponding spacing gap 350 may be the smallest. Therefore, in order to provide effective thermal insulation, the insulating through hole 120 may be provided in front of the first heat transfer portion 311 corresponding to the power board 410.

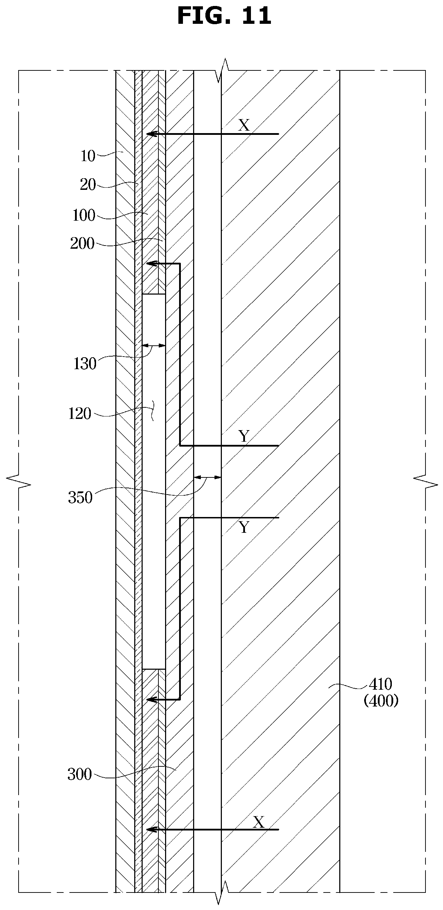

FIG. 11 is a conceptual view of a cutaway cross-section of the display device 1 of FIG. 1.

As shown in FIG. 11, the heat dissipation sheet 20 may be attached to the rear side of the display panel 10. The inner plate 100 may be positioned on a rear side of the heat dissipation sheet 20. The inner plate 100 may be attached to the rear chassis 300, which is positioned on the rear side of the inner plate 100, by an adhesive member 200, which is positioned on the rear side of the inner plate 100. The electrical components 400 may be positioned on the rear side of the rear chassis 300. In FIG. 11, as an example, it is assumed and shown that the electrical component 400 is the power board 410.

The inner plate 100 may be attached to the rear chassis 300 by the adhesive member 200. Here, the adhesive member 200 may be an adhesive or a double-sided tape.

The air gap 130 may be formed from the front side of the rear chassis 300 to the rear side of the display panel 10 by the insulating through hole 120. More precisely, the air gap 130 may be formed from the front side of the rear chassis 300 to the rear side of the heat dissipation sheet 20.

In other words, the air gap 130 may be formed to extend from the front side of the rear chassis 300 to the insulating through hole 120.

The air gap 130 may be sized to correspond to the thickness of the adhesive member 200 plus the thickness of the inner plate 100. Since the display device 1 is preferably formed thin, the thickness of the air gap 130 is preferably 1 mm or less.

A first heat transfer path X may formed in which heat from the electrical components 400 flows through the rear chassis 300 and the inner plate body 101 to the display panel 10.

A second heat transfer path Y may be formed in which heat from the electrical components 400 flows through the rear chassis 300 and bypasses the insulation region 110 of the inner plate 100 to the display panel 10.

Hereinafter, another embodiment of the display device 1 will be described as an example in which the present disclosure is implemented. In the following description, the same configurations as those of the display device 1 above are given the same reference numerals, and detailed descriptions thereof may be omitted.

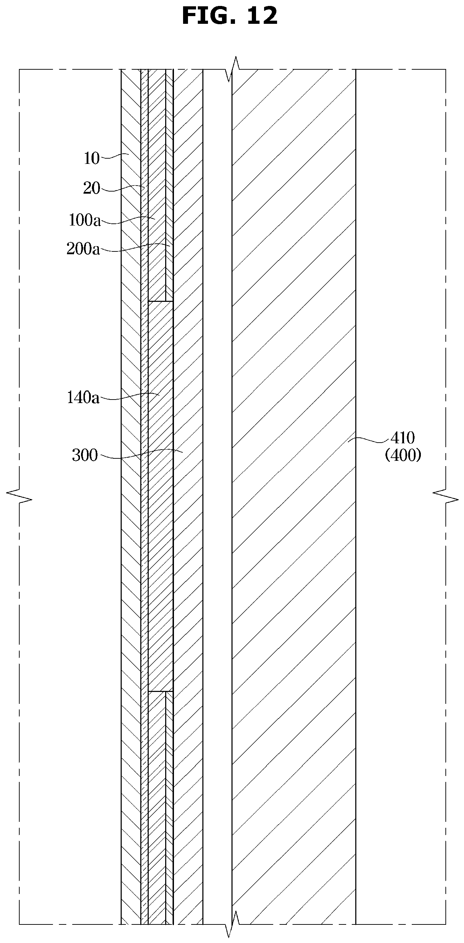

FIG. 12 is a conceptual view of a cutaway cross-section of the display device 1 of FIG. 1 according to another embodiment of the present disclosure.

As shown in FIG. 12, the air gap 130 formed by the insulating through hole 120 in the embodiment described above may be filled with another thermal insulation material. The thermal insulation material filled in such a manner may form a heat insulating layer 140a.

It should be understood that the heat insulating layer 140a has a lower heat transfer coefficient than the inner plate body 101.

As such, when the heat insulation layer 140a is formed, the rigidity of the display device 1a may be increased compared to when the insulation region 110 is an empty space.

Although certain example embodiments are illustrated and described above, the present disclosure is not limited to the certain embodiments, various applications may of course be performed by those skilled in the art without deviating from what is claimed in the scope of claims, and such applications should not be understood separately from the technical idea or prospects herein.

## Claims

1. A display device (1) comprising:
a display panel (10);
an electrical component (400) located on a rear side of the display panel (10) and releasing heat; and
an inner plate (100) located on the rear side of the display panel (10),
wherein the inner plate (100) comprises:
an inner plate body (101); and
an insulation region (110) formed at a position corresponding to a position of the electrical component (400) and having a heat transfer coefficient lower than a heat transfer coefficient of the inner plate body (101) to reduce transfer of heat generated from the electrical component (400) to the display panel (10), wherein an insulating through hole (120) is formed in the insulation region (110) to allow an air gap (130) to be formed between the electrical component (400) and the display panel (10), wherein the insulating through hole (120) is formed by cutting the inner plate (100), further comprising a rear chassis (300) attached to a rear side of the inner plate (100) to support the display panel (10),
wherein the electrical component (400) is mountable on a rear side of the rear chassis (300),
the rear chassis (300) includes a heat transfer portion (310) at a position corresponding to the electrical component (400), and
the insulating through hole (120) is formed to correspond to the heat transfer portion (310).

2. The display device of claim 1, wherein
the rear chassis (300) and the inner plate (100) are attached by an adhesive member between the rear chassis (300) and the inner plate (100), and
the air gap (130) is formed to extend from a front side of the rear chassis (300) to the insulating through hole (120).

3. The display device of claim 1, wherein a strength of the inner plate (100) and the rear chassis (300) changes by 10% or less when the insulating through hole (120) is formed.

4. The display device of claim 2, wherein the rear chassis (300) comprises:
a rear chassis body (301) including the heat transfer portion (310), and
a spacing bead (340) protruding from the rear chassis body (301) toward the electrical component (400) to form a spacing gap (350) between the electrical component (400) and the heat transfer portion (310).

5. The display device of claim 4, wherein
the electrical component (400) includes a first electrical component (410) and a second electrical component (420),
the heat transfer portion (310) includes a first heat transfer portion (311) corresponding to the first electrical component (410) and a second heat transfer portion (420) corresponding to the second electrical component (420),
the spacing bead (340) includes a first spacing bead (341) formed at a position corresponding to a position of the first electrical component (410) and located adjacent to the first heat transfer portion (311), and a second spacing bead (342) formed at a position corresponding to a position of the second electrical component (420), protruding further rearward than the first spacing bead (341), and located adjacent to the second heat transfer portion (312), and
the insulating through hole (120) is formed on a front side of the first heat transfer portion (311).

6. The display device of claim 5, further comprising a rear cover (40) disposable on the rear side of the rear chassis (300) to cover the first electrical component (410) and the second electrical component (420),
wherein a thickness of the first electrical component (410) in a front-to-back direction is thicker than a thickness of the second electrical component in the front-to-back direction.

7. The display device of claim 5, wherein
the first electrical component (410) includes a power board, and
the second electrical component (420) includes a display control board.

8. The display device of claim 7, wherein
the power board includes a transformer (411) enabled to convert an alternating current voltage into a direct current voltage, and
the insulation region (110) is formed to correspond to a position of the transformer (411).

9. The display device of claim 2, wherein a size of the air gap (130) is 1 mm or less.

10. The display device of claim 6, further comprising a stand (50) disposed on a rear side of the rear cover (40) and supporting the display panel (10),
wherein the second electrical component is located facing the stand (50), and
the first electrical component (410) is located adjacent to the second electrical component (420).

11. The display device of claim 10, wherein
a substrate (13) controlling the display panel (10) is arranged on a lower side of the rear chassis (300), and
the insulation region (110) is located to be spaced apart from the substrate (13).

12. The display device of claim 1, wherein
a first heat transfer path is formed in which heat from the electrical component (400) flows through the rear chassis (300) and the inner plate body (101) to the display panel (10), and
a second heat transfer path is formed in which heat from the electrical component (400) flows through the rear chassis (300) and bypasses the insulation region (110) of the inner plate (100) to the display panel (10).

## Patentansprüche

1. Anzeigevorrichtung (1), umfassend:
eine Anzeigetafel (10);
eine elektrische Komponente (400), die sich auf einer Rückseite der Anzeigetafel (10) befindet und Wärme freisetzt; und
eine Innenplatte (100), die sich auf der Rückseite der Anzeigetafel (10) befindet,
wobei die Innenplatte (100) Folgendes umfasst:
einen Innenplattenkörper (101); und
einen Isolierbereich (110), der an einer Position gebildet ist, die einer Position der elektrischen Komponente (400) entspricht, und einen Wärmeübertragungskoeffizienten aufweist, der niedriger als ein Wärmeübertragungskoeffizient des Innenplattenkörpers (101) ist, um eine Übertragung von Wärme, die von der elektrischen Komponente (400) erzeugt wird, auf die Anzeigetafel (10) zu reduzieren, wobei ein isolierendes Durchgangsloch (120) in dem Isolierbereich (110) gebildet ist, um zu ermöglichen, dass ein Luftspalt (130) zwischen der elektrischen Komponente (400) und der Anzeigetafel (10) gebildet wird, wobei das isolierende Durchgangsloch (120) durch Schneiden der Innenplatte (100) gebildet wird, ferner umfassend ein hinteres Chassis (300), das an einer Rückseite der Innenplatte (100) angebracht ist, um die Anzeigetafel (10) zu tragen, wobei die elektrische Komponente (400) auf einer Rückseite des hinteren Chassis (300) montierbar ist,
das hintere Chassis (300) einen Wärmeübertragungsabschnitt (310) an einer der elektrischen Komponente (400) entsprechenden Position beinhaltet und
das isolierende Durchgangsloch (120) so gebildet ist, dass es dem Wärmeübertragungsabschnitt (310) entspricht.

2. Anzeigevorrichtung nach Anspruch 1, wobei
das hintere Chassis (300) und die Innenplatte (100) durch ein Klebeelement zwischen dem hinteren Chassis (300) und der Innenplatte (100) angebracht sind und
der Luftspalt (130) so gebildet ist, dass er sich von einer Vorderseite des hinteren Chassis (300) zu dem isolierenden Durchgangsloch (120) erstreckt.

3. Anzeigevorrichtung nach Anspruch 1, wobei sich eine Festigkeit der Innenplatte (100) und des hinteren Chassis (300) um 10 % oder weniger ändert, wenn das isolierende Durchgangsloch (120) gebildet wird.

4. Anzeigevorrichtung nach Anspruch 2, wobei das hintere Chassis (300) Folgendes umfasst:
einen hinteren Chassiskörper (301), der den Wärmeübertragungsabschnitt (310) beinhaltet, und
eine Abstandswulst (340), die von dem hinteren Chassiskörper (301) hin zu der elektrischen Komponente (400) vorsteht, um einen Abstandsspalt (350) zwischen der elektrischen Komponente (400) und dem Wärmeübertragungsabschnitt (310) zu bilden.

5. Anzeigevorrichtung nach Anspruch 4, wobei
die elektrische Komponente (400) eine erste elektrische Komponente (410) und eine zweite elektrische Komponente (420) beinhaltet,
der Wärmeübertragungsabschnitt (310) einen ersten Wärmeübertragungsabschnitt (311), welcher der ersten elektrischen Komponente (410) entspricht, und einen zweiten Wärmeübertragungsabschnitt (420), welcher der zweiten elektrischen Komponente (420) entspricht, beinhaltet,
die Abstandswulst (340) eine erste Abstandswulst (341), die an einer Position gebildet ist, die einer Position der ersten elektrischen Komponente (410) entspricht und sich an den ersten Wärmeübertragungsabschnitt (311) angrenzend befindet, und eine zweite Abstandswulst (342) beinhaltet, die an einer Position gebildet ist, die einer Position der zweiten elektrischen Komponente (420) entspricht, wobei sie weiter rückwärts vorsteht als die erste Abstandswulst (341) und sich an den zweiten Wärmeübertragungsabschnitt (312) angrenzend befindet, und
das isolierende Durchgangsloch (120) auf einer Vorderseite des ersten Wärmeübertragungsabschnitts (311) gebildet ist.

6. Anzeigevorrichtung nach Anspruch 5, ferner umfassend eine hintere Abdeckung (40), die auf der Rückseite des hinteren Chassis (300) anordenbar ist, um die erste elektrische Komponente (410) und die zweite elektrische Komponente (420) abzudecken,
wobei eine Dicke der ersten elektrischen Komponente (410) in einer Richtung von vorne nach hinten dicker ist als eine Dicke der zweiten elektrischen Komponente in der Richtung von vorne nach hinten.

7. Anzeigevorrichtung nach Anspruch 5, wobei
die erste elektrische Komponente (410) eine Leistungsplatine beinhaltet und
die zweite elektrische Komponente (420) eine Anzeigesteuerplatine beinhaltet.

8. Anzeigevorrichtung nach Anspruch 7, wobei
die Leistungsplatine einen Transformator (411) beinhaltet, der imstande ist, eine Wechselspannung in eine Gleichspannung umzuwandeln, und
der Isolierbereich (110) so gebildet ist, dass er einer Position des Transformators (411) entspricht.

9. Anzeigevorrichtung nach Anspruch 2, wobei eine Größe des Luftspalts (130) 1 mm oder weniger beträgt.

10. Anzeigevorrichtung nach Anspruch 6, ferner umfassend einen Ständer (50), der auf einer Rückseite der hinteren Abdeckung (40) angeordnet ist und die Anzeigetafel (10) trägt,
wobei die zweite elektrische Komponente dem Ständer (50) zugewandt befindlich ist und
die erste elektrische Komponente (410) an die zweite elektrische Komponente (420) angrenzend befindlich ist.

11. Anzeigevorrichtung nach Anspruch 10, wobei
ein Substrat (13) zur Steuerung der Anzeigetafel (10) auf einer unteren Seite des hinteren Chassis (300) angeordnet ist und
der Isolierbereich (110) so befindlich ist, dass er von dem Substrat (13) beabstandet ist.

12. Anzeigevorrichtung nach Anspruch 1, wobei
ein erster Wärmeübertragungsweg gebildet ist, in dem Wärme von der elektrischen Komponente (400) durch das hintere Chassis (300) und den Innenplattenkörper (101) zu der Anzeigetafel (10) fließt und
ein zweiter Wärmeübertragungsweg gebildet ist, in dem Wärme von der elektrischen Komponente (400) durch das hintere Chassis (300) fließt und den Isolierbereich (110) der Innenplatte (100) zu der Anzeigetafel (10) umgeht.

## Revendications

1. Dispositif d'affichage (1) comprenant :
un panneau d'affichage (10) ;
un composant électrique (400) situé sur un côté arrière du panneau d'affichage (10) et libérant de la chaleur ; et
une plaque interne (100) située sur la face arrière du panneau d'affichage (10),
ladite plaque interne (100) comprenant :
un corps (101) de plaque interne ; et
une zone d'isolation (110) formée au niveau d'une position correspondant à une position du composant électrique (400) et possédant un coefficient de transfert de chaleur inférieur à un coefficient de transfert de chaleur du corps (101) de plaque interne pour réduire le transfert de chaleur généré à partir du composant électrique (400) au panneau d'affichage (10), un trou traversant isolant (120) étant formé dans la zone d'isolation (110) pour permettre la formation d'un intervalle d'air (130) entre le composant électrique (400) et le panneau d'affichage (10), ledit trou traversant isolant (120) étant formé en coupant la plaque interne (100), comprenant en outre un châssis arrière (300) fixé à un côté arrière de la plaque interne (100) pour supporter le panneau d'affichage (10),
ledit composant électrique (400) pouvant être monté sur un côté arrière du châssis arrière (300),
ledit châssis arrière (300) comprenant une partie de transfert de chaleur (310) au niveau d'une position correspondant au composant électrique (400), et
ledit trou traversant isolant (120) étant formé pour correspondre à la partie de transfert de chaleur (310).

2. Dispositif d'affichage de la revendication 1,
ledit châssis arrière (300) et ladite plaque interne (100) étant fixés par un élément adhésif entre ledit châssis arrière (300) et ladite plaque interne (100), et
ledit intervalle d'air (130) étant formé pour s'étendre à partir d'un côté avant du châssis arrière (300) vers le trou traversant isolant (120).

3. Dispositif d'affichage de la revendication 1, une résistance de la plaque interne (100) et du châssis arrière (300) changeant de 10 % ou moins lorsque le trou traversant isolant (120) est formé.

4. Dispositif d'affichage de la revendication 2, ledit châssis arrière (300) comprenant :
un corps (301) de châssis arrière comprenant la partie de transfert de chaleur (310), et
un bourrelet d'espacement (340) faisant saillie à partir du corps (301) de châssis arrière vers le composant électrique (400) pour former un intervalle d'espacement (350) entre le composant électrique (400) et la partie de transfert de chaleur (310).

5. Dispositif d'affichage de la revendication 4,
ledit composant électrique (400) comprenant un premier composant électrique (410) et un second composant électrique (420),
ladite partie de transfert de chaleur (310) comprenant une première partie de transfert de chaleur (311) correspondant au premier composant électrique (410) et une seconde partie de transfert de chaleur (420) correspondant au second composant électrique (420),
ledit bourrelet d'espacement (340) comprenant un premier bourrelet d'espacement (341) formé au niveau d'une position correspondant à une position du premier composant électrique (410) et situé adjacent à la première partie de transfert de chaleur (311), et un second bourrelet d'espacement (342) formé au niveau d'une position correspondant à une position du second composant électrique (420), faisant saillie plus en arrière que le premier bourrelet d'espacement (341), et situé adjacent à la seconde partie de transfert de chaleur (312), et
ledit trou traversant isolant (120) étant formé sur un côté avant de la première partie de transfert de chaleur (311).

6. Dispositif d'affichage de la revendication 5, comprenant en outre un couvercle arrière (40) pouvant être disposé sur le côté arrière du châssis arrière (300) pour recouvrir le premier composant électrique (410) et le second composant électrique (420),
une épaisseur du premier composant électrique (410) dans une direction avant-arrière étant plus épaisse qu'une épaisseur du second composant électrique dans la direction avant-arrière.

7. Dispositif d'affichage de la revendication 5,
ledit premier composant électrique (410) comprenant une carte d'alimentation, et
ledit second composant électrique (420) comprenant un tableau de commande d'affichage.

8. Dispositif d'affichage de la revendication 7,
ladite carte de puissance comprenant un transformateur (411) activé pour convertir une tension alternative en une tension continue, et
ladite zone d'isolation (110) étant formée pour correspondre à une position du transformateur (411).

9. Dispositif d'affichage de la revendication 2, une taille de l'intervalle d'air (130) étant inférieur ou égal à 1 mm.

10. Dispositif d'affichage de la revendication 6, comprenant en outre un support (50) disposé sur un côté arrière du couvercle arrière (40) et supportant le panneau d'affichage (10),
ledit second composant électrique étant situé faisant face au support (50), et
ledit premier composant électrique (410) étant situé adjacent au second composant électrique (420).

11. Dispositif d'affichage de la revendication 10,
un substrat (13) commandant le panneau d'affichage (10) étant agencé sur un côté inférieur du châssis arrière (300), et
ladite zone d'isolation (110) étant située pour être espacée du substrat (13).

12. Dispositif d'affichage de la revendication 1,
un premier trajet de transfert de chaleur étant formé dans lequel la chaleur provenant du composant électrique (400) circule à travers le châssis arrière (300) et le corps (101) de plaque interne jusqu'au panneau d'affichage (10), et
un second trajet de transfert de chaleur étant formé dans lequel la chaleur provenant du composant électrique (400) circule à travers le châssis arrière (300) et contourne la zone d'isolation (110) de la plaque interne (100) jusqu'au panneau d'affichage (10).
